# FASCICULE DE BREVET EUROPEEN

(11) **EP 0 411 985 B1**
(45) Date de publication et mention de la délivrance du brevet: **15.12.1993**
(21) Numéro de dépôt: 90402104.5
(22) Date de dépôt: 23.07.1990
(51) Int. Cl.: H05K 3/40, H01L 21/48

(54) **Procédé de formation du réseau multicouche d'une carte de connexion d'au moins un circuit intégré de haute densité**
Verfahren zur Herstellung von einem mehrschichtigen Leitungsnetz einer Verbindungsplatte für mindestens eine höchstintegrierte Schaltung
Process of making a multilayer network of a connection board for at least one very large scale integrated circuit

(30) Priorité: 27.07.1989 FR 8910157
(43) Date de publication de la demande: 06.02.1991
(73) Titulaire: BULL S.A., 92800 Puteaux (FR)
(72) Inventeur: Chantraine, Philippe, F-75116 Paris (FR); Zorrilla, Marta, F-75116 Paris (FR)
(74) Mandataire: Denis, Hervé

(56) Documents cités:
- FR-A- 2 133 156
- FR-A- 2 622 384
- IBM TECHNICAL DISCLOSURE BULLETIN, vol. 21, no. 4, septembre 1978, pages 1369-1397, New York, US; D.R. TOMSA et al.: "Multilayer laminated chip carrier"

## Description

L'invention a pour objet un procédé de formation du réseau multicouche d'une carte de connexion d'au moins un circuit intégré de haute densité encore appelé circuit VLSI (Very Large Scale Integrated circuit). La carte peut servir à l'interconnexion de plusieurs circuits intégrés montés en surface ou simplement de support d'un circuit intégré placé dans un boîtier, par exemple en substitution du support classique actuel couramment appelé "chip carrier".

Dans une telle carte, le réseau multicouche est ordinairement porté par un substrat fait d'une plaque isolante incorporant les plans de distribution des potentiels d'alimentation du ou des circuits intégrés. Le substrat peut être une plaque de céramique cocuite, ou une plaque faite d'un matériau organique, en plastique par exemple. Cependant, la carte pourrait être simplement formée du réseau multicouche prenant la forme d'une carte souple. La carte peut encore être une plaque de matériau semiconducteur incorporant des circuits intégrés et recouverte d'un réseau multicouche pour l'interconnexion de ces circuits intégrés selon la technologie dite WSI (Wafer Scale Integration). Dans toutes ces cartes, le réseau multicouche se compose d'un empilement de couches conductrices et isolantes alternées. Dans cet empilement, une couche isolante est percée de traversées pour la liaison électrique des couches conductrices adjacentes. La couche conductrice est ordinairement faite d'aluminium ou de cuivre, et la couche isolante est aujourd'hui faite de préférence en un matériau polymérisé tel que le polyimide.

Un problème dans la fabrication du réseau multicouche réside dans l'obtention de couches relativement planes. Un procédé classique de fabrication consiste à former les conducteurs d'une couche conductrice et à recouvrir la couche conductrice d'une couche isolante de matériau polymérisable sous forme de liquide visqueux, appelé couramment pâte. Cette pâte offre l'avantage d'avoir une surface présentant des marches ou dénivellations moins hautes que les bords correspondants des conducteurs sous-jacents. Ce procédé peut consister en l'étalement centrifuge d'une goutte d'un matériau polymérisable, ou en une pulvérisation de la pâte, ou encore en une enduction de la pâte, par sérigraphie par exemple. La pâte est ensuite polymérisée. Naturellement, les conditions de mise en oeuvre de ce procédé confèrent à la couche polymérisée la grande épaisseur requise pour assurer l'isolation désirée entre deux couches conductrices superposées. La couche isolante est recouverte d'un masque définissant les emplacement des traversées (via - holes en terminologie anglo-saxonne) à former. Selon un mode de réalisation classique, les traversées sont évasées, et les conducteurs de la couche conductrice supérieure s'étendent sur la couche isolante et sur les parois des traversées qui viennent d'être formées, ainsi que sur les régions des conducteurs constituant le fond des traversées. Il en résulte une couche conductrice supérieure pourvue de nombreuses dépressions au niveau des traversées. On comprend que l'empilement de nombreuses couches accentue la profondeur des dépressions et risque en conséquence de créer des discontinuités dans les couches conductrices déposées. De plus, la formation et l'évasement des traversées sont des étapes délicates du procédé.

Un perfectionnement à ce procédé consiste à éviter la superposition de traversées, en les décalant en spirale autour d'une ligne verticale. Un premier inconvénient est de réduire la densité des traversées dans une même couche isolante et, par voie de conséquence, de réduire la densité globale des conducteurs dans le réseau multicouche. Comme second inconvénient, la disposition décalée des traversées limite quand même très vite le nombre de couches fiables dans le réseau. Par exemple, une disposition en spirale à 90° les unes des autres fait qu'une traversée de la cinquième couche se superpose à une traversée de la première couche et subit les déformations occasionnées par les quatre traversées intermédiaires. En pratique, ce procédé est ordinairement limité au dépôt de l'ordre de cinq couches conductrices superposées.

Une solution plus récente au problème consiste à former des piliers sur des conducteurs d'une couche conductrice et à recouvrir l'ensemble d'une pâte que l'on polymérise pour obtenir la couche isolante. La couche isolante a la grande épaisseur requise pour assurer l'isolation désirée entre deux couches conductrices superposées et recouvre les piliers d'une plus faible épaisseur de matériau isolant. La couche isolante est recouverte d'un masque ayant la configuration des traversées. On procède alors à une attaque sélective de la couche isolante pour découvrir les faces supérieures des piliers et pour évaser les traversées. A cause des piliers, ces traversées sont nettement moins profondes que celles obtenues par le procédé décrit dans le paragraphe précédent. La couche conductrice supérieure est donc relativement plus aplanie. Ce procédé offre ainsi l'avantage d'empiler un plus grand nombre de couches conductrices fiables dans le réseau multicouche. L'invention se rapporte à cette technologie et présente un procédé de formation d'un réseau multicouche pourvu de piliers pour une carte de connexion de circuit intégré.

Le procéde conforme à l'invention pour la formation du réseau multicouche d'une carte de connexion d'au moins un circuit intégré de haute densité comprenant la formation de piliers sur les conducteurs d'une couche métallique du réseau, est caractérisé par les caractéristiques de la revendication 1.

Les caractéristiques et avantages de l'invention ressortiront de la description qui suit, donnée à titre d'exemple et faite en référence aux dessins annexés.

Dans les dessins :
- la figure 1 est une vue en coupe partielle transversale d'une carte multicouche fabriquée conformément à l'invention pour le support d'au moins un circuit intégré de haute densité ;
- les figures 2A à 2H sont des vues de détail agrandi de la région A de la carte représentée sur la figure 1, illustrant respectivement des phases successives d'un procédé conforme à l'invention pour la fabrication de la carte ;
- les figures 3A à 3H sont des vues en coupe faite suivant la ligne III-III de la région A de la carte représentée sur la figure 1, illustrant respectivement les phases successives correspondant aux figures 2A-2H du procédé conforme à l'invention ; et
- la figure 4 est une vue en coupe similaire à celle des figures 2A-2H, illustrant une phase d'une variante du procédé conforme à l'invention.

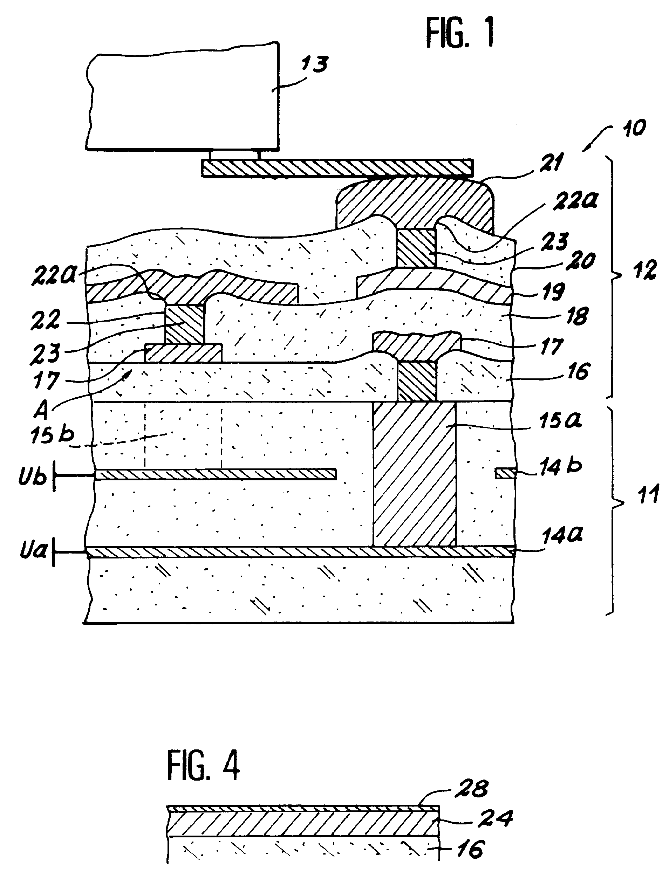

La figure 1 présente une carte 10 vue en coupe partielle, résultant de la mise en oeuvre du procédé conforme à l'invention. La carte 10 se compose d'un substrat 11 portant sur une face un réseau multicouche 12 pour la connexion d'au moins un circuit intégré 13. Le substrat 11 est une plaque massive faite d'un matériau électriquement isolant, de céramique dans l'exemple illustré, incorporant des plans conducteurs 14a, 14b de distribution des potentiels respectifs Ua, Ub d'alimentation du circuit intégré 13. De nombreux piliers conducteurs 15a, 15b traversent le substrat 11, faisant contact avec les plans de potentiel respectifs 14a, 14b et émergeant sur une même face du substrat 11. Le réseau multicouche 12 est formé sur cette face du substrat 11 et consiste en un empilement de couches conductrices et isolantes alternées. Le réseau illustré 12 comprend une première couche isolante 16, une première couche conductrice 17, une seconde couche isolante 18, une seconde couche conductrice 19, une troisième couche isolante 20, et une couche conductrice d'assemblage 21 faite de plages pour la connexion du circuit intégré 13. En pratique, le substrat 11 de céramique était une plaque de 100 mm x 100 mm et de 1 mm environ d'épaisseur. Le réseau 12 était fait de cuivre et de polyimide. Chaque couche conductrice avait une épaisseur d'environ 5 micromètres, et se composait de conducteurs de 50 micromètres de large alignés au pas de 100 micromètres. Chaque couche isolante avait une épaisseur de l'ordre de 15 micromètres au-dessus de la couche isolante sous-jacente. Bien que la face supérieure du substrat de céramique 11 soit isolante, elle présente de nombreuses aspérités et défauts de planéité que l'on masque en déposant la première couche isolante 16. De manière classique, les couches isolantes 16, 18, 20 sont pourvues de traversées 22 contenant des piliers 23 pour la liaison électrique des couches conductrices adjacentes 17, 19 et 21 entre elles ainsi qu'avec les piliers 15a, 15b. Les traversées 22 présentent des bords évasés 22a au-dessus des piliers 23. Les piliers 23 peuvent avoir une section transversale cylindrique ou prismatique. Les piliers 23 réalisés étaient octogonaux et avaient un diamètre de 30 micromètres et une hauteur de 10 micromètres au-dessus des conducteurs.

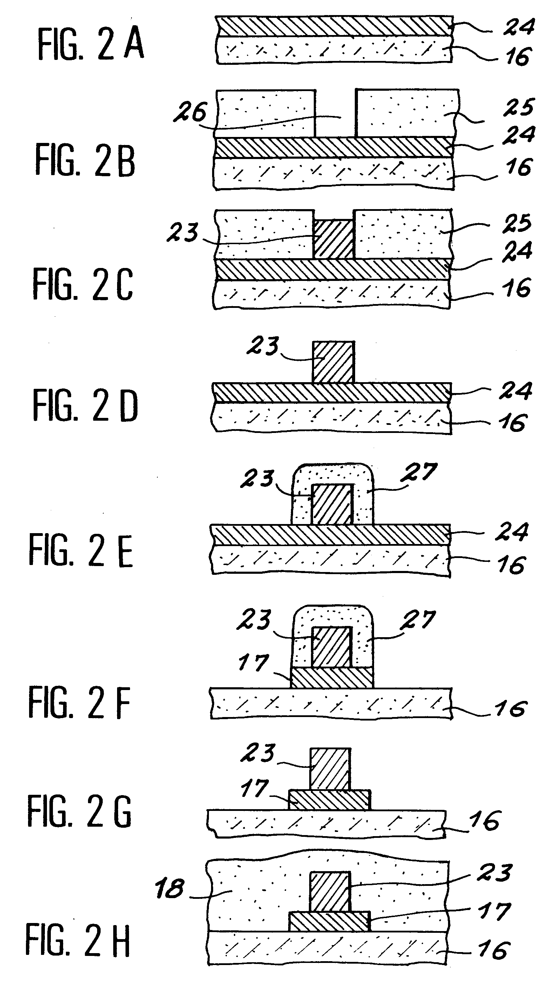

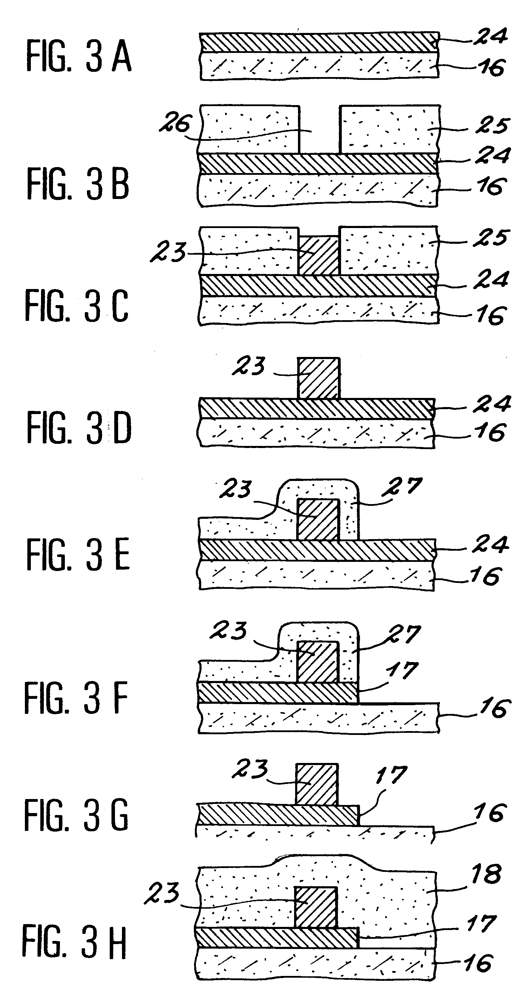

Les figures 2A à 2H, de même que les figures 3A-3H vues dans un plan perpendiculaire, illustrent respectivement des phases successives d'un procédé conforme à l'invention pour la fabrication de la carte 10 représentée sur la figure 1. Les figures 2A à 2H et 3A-3H sont des vues en coupe de détail agrandi faites au niveau de la région A représentée sur la figure 1 et illustrant successivement la formation de la couche conductrice 17 sur la couche isolante 16, des piliers 23 placés sur la couche conductrice 17, et de la couche isolante 18. Le procédé illustré commence après la formation de la couche isolante 16.

La couche isolante 16 est uniformément recouverte d'une couche de cuivre 24 ayant l'épaisseur de la couche conductrice 17 à former (figures 2A et 3A). La couche 24 a avantageusement été déposée par un procédé de pulvérisation cathodique par magnétron. La couche 24 est ensuite recouverte uniformément d'un masque photosensible 25 traité pour présenter des traversées 26 conformées au motif des piliers 23 (figures 2B et 3B). La couche uniforme de cuivre 24 sert alors d'électrode pour le dépot électrolytique des piliers 23 dans les traversées 26 du masque 25 (figures 2C et 3C). Le masque 25 est éliminé (figure 2D et 3D) pour être remplacé par un autre masque photosensible 27 recouvrant les piliers 23 et traité pour dessiner le motif des conducteurs de la couche conductrice 17 (figures 2E et 3E). La couche de cuivre 24 est alors gravée (figures 2F et 3F). Le masque 27 recouvrant les conducteurs de la couche 17 est alors éliminé (figures 2G et 3G).

La couche isolante 18 peut être formée selon différents procédés connus. Dans l'exemple illustré, on a mis en oeuvre le procédé bien connu consistant à étaler par la force centrifuge un acide polyamique sous forme visqueux, puis à polymériser la couche obtenue pour en faire un polyimide. Il en est résulté la couche de polyimide 18 représentée les figures 2H et 3H. Ce procédé a l'avantage de lisser sensiblement le relief des conducteurs de la couche 17 pourvue des piliers 23. Grâce à ce procédé, la couche 18 ne laisse qu'une plus faible épaisseur de polyimide au-dessus de chaque pilier 23, comme illustré dans les figures 2H et 3H. Les traversées évasées 22a de la couche isolante 18 représentée sur la figure 1 ont été obtenues de manière classique par formation d'un masque sur la couche 18 représentée sur les figures 2H et 3H et par attaque sélective par plasma mettant à nu les faces supérieures des piliers 23. On notera que les traversées 22a ont une faible épaisseur et qu'elles déforment peu la couche conductrice supérieure 19.

Diverses variantes du procédé qui vient d'être décrit sont possibles. Par exemple, la couche 24 de cuivre peut être faite selon tout procédé connu. En outre, au lieu du cuivre comme matériau constituant les couches conductrices 17, 19, 21 et les piliers 23, il est possible d'utiliser tout autre métal conducteur, pur ou en combinaison avec d'autres constituants, approprié au dépôt électrolytique des piliers 23 et formé sous forme de couche 24 par tout procédé connu. Cependant, il est aussi possible que la nature du matériau constituant les conducteurs de la couche 17 ne permette pas le dépôt électrolytique des piliers 23. C'est le cas par exemple où les conducteurs 17 sont en aluminium. Dans ce cas, la figure 4 est une vue similaire à celles des figures 2A-2H, illustrant une étape supplémentaire du procédé représenté. Ainsi, dans la figure 2A, on suppose que la couche métallique 24 est faite d'aluminium. Dans la figure 4, la couche 24 est recouverte d'un film conducteur 28, de cuivre par exemple, permettant le dépôt électrolytique de piliers 23 de cuivre et éventuellement la compatibilité avec l'aluminium. Après dépôt du masque 25 (figure 28), les piliers de cuivre 23 sont alors formés. Le film 28 est éliminé au moins en partie, après l'étape représentée sur la figure 2D ou sur la figure 2E, pour assurer l'isolation électrique entre les conducteurs.

On a vu aussi que la couche isolante 18 pouvait être faite selon différents procédés connus. Un procédé avantageux pourrait consister par exemple à étendre sur la couche conductrice 17 pourvue des piliers 23 (figures 2G et 3G) une pellicule de polyimide de l'ordre de 30 micromètres d'épaisseur et à presser à chaud la pellicule pour obtenir une structure analogue à celle des figures 2H et 3H. L'épaisseur de polyimide au-dessus des piliers 23 pourrait être enlevée par érosion mécanique, ou par attaque chimique ou par plasma. Bien entendu, le polyimide est donné à titre d'exemple comme élément couramment utilisé dans les réseaux multicouches et pourrait être remplacé par tout autre matériau adapté à la technologie des réseaux multicouches.

## Revendications

1. Procédé de formation du réseau multicouche (12) d'une carte (10) de connexion d'au moins un circuit intégré de haute densité (13), comprenant la formation de piliers (23) sur les conducteurs (17) d'une couche métallique du réseau multicouche, caractérisé en ce qu'il consiste à former la couche métallique de façon uniforme (24) et ayant l'épaisseur des conducteurs (17) à former, à constituer un masque (25) pourvu de traversées (26) conformées au motif des piliers (23), à former les piliers dans les traversées, à éliminer le masque (25) et à former un second masque (27) conformé au motif des conducteurs (17) à former, et à graver la couche métallique (24) pour constituer les conducteurs (17).

2. Procédé selon la revendication 1, caractérisé en ce qu'il consiste à recouvrir la couche métallique uniforme (24) d'un film conducteur (28) permettant le dépôt électrolytique des piliers, et à éliminer au moins en partie le film (28) après formation des piliers.

3. Procédé selon la revendication 1 ou 2, caractérisé en ce que le réseau métallique est fait d'un même métal, tel que le cuivre.

## Patentansprüche

1. Verfahren zur Bildung des Mehrschichtnetzes (12) einer Verbindungskarte (10) für wenigstens einen integrierten Schaltkreis (13) hoher Dichte, bei dem Pfeiler (23) auf den Leitern (17) einer Metallschicht des Mehrschichtnetzes gebildet werden, dadurch gekennzeichnet, daß bei bei ihm die Metallschicht gleichförmig (24) und mit der Dicke der Leiter (17) gebildet wird, daß eine Maske (25) gebildet wird, die mit Durchführungen (26) versehen ist, die an das Muster der Pfeiler (23) angepaßt sind, daß die Pfeiler in den Durchführungen gebildet werden, daß die Maske (25) entfernt und eine zweite Maske (27) gebildet wird, die dem Muster der zu bildenden Leiter (17) angepaßt ist, und daß die Metallschicht (24) zur Bildung der Leiter (17) geätzt wird.

2. Verfahren nach Anspruch 1, dadurch gekennzeichnet, daß bei ihm die gleichförmige Metallschicht (24) von einem Leiterfilm (28) bedeckt wird, der das elektrolytische Aufbringen der Pfeiler ermöglicht, und daß nach der Bildung der Pfeiler der Film (28) wenigstens teilweise entfernt wird.

3. Verfahren nach Anspruch 1 oder 2, dadurch gekennzeichnet, daß das Metallnetz aus einem gleichen Metall wie Kupfer ausgeführt wird.

## Claims

1. Method of forming the multi-layer network (12) of a connection card (10) of at least one high density integrated circuit (13), including the formation of vias (23) on the conductors (17) of a metal layer of the multi-layer structure, characterised in that it consists of forming the metal layer in a uniform manner (24) and having the thickness of the conductors (17) to be formed, constituting a mask (25) provided with via-holes (26) matching the pattern of the vias (23), forming the vias in the via-holes, eliminating the mask (25) and forming a second mask (27) matching the pattern of the conductors (17) to be formed, and etching the metal layer (24) to constitute the conductors.

2. Method according to claim 1, characterised in that it comprises covering the uniform metal layer (24) with a conductive film (28) enabling the electrolytic deposition of the vias, and eliminating at least a portion of the film (28) after formation of the vias.

3. Method according to claim 1 or 2, characterised in that the metal network is made of the same metal, such as copper.
